# EUROPÄISCHE PATENTANMELDUNG

(11) **EP 0 539 351 A1**
(43) Veröffentlichungstag der Anmeldung: **28.04.1993**
(21) Anmeldenummer: 92890227.9
(22) Anmeldetag: 22.10.1992
(51) Int. Cl.: G01R 19/15, H01H 36/00

(54) **Gerät zur Anzeige eines stattgefundenen Stromdurchganges in Leitungen von Blitzschutzanlagen**

(30) Priorität: 24.10.1991 AT 2121/91
(60) Teilanmeldung: 95106157.1
(71) Anmelder: Gerstmaier, Siegfried, A-1150 Wien (AT)
(72) Erfinder: Cerny, Alfred, Ing., A-2345 Brunn am Gebirge (AT)
(74) Vertreter: Rippel, Andreas, Dipl.-Ing.

(57) **Zusammenfassung**

Ein Gerät zur Anzeige eines stattgefundenen Stromdurchganges in Leitungen von Blitzschutzanlagen weist ein Gehäuse (2) insbesondere aus Kunststoff auf, durch das ein Metallstab (1) hindurchgeführt ist. Eine Führung (4) endet in einer mit einer durchsichtigen Scheibe (6) abgedeckten Tasche (5). Am Metallstab (1) haftet ein Magnet (7).

Der Metallstab (1) ist mit einer Blitzschutzanlage verbunden, so daß bei einem Einschlag durch ihn Strom fließt. Der Magnet (7) fällt dann ab und fällt in die Tasche (5), wo er sichtbar ist.

## Beschreibung

Die Erfindung bezieht sich auf ein Gerät zur Anzeige eines stattgefundenen Stromdurchganges in Leitungen von Blitzschutzanlagen.

Derartige Geräte sind zweckmäßig, um jederzeit feststellen zu können, ob ein Blitzeinschlag stattgefunden hat. War dies der Fall, könnte die Blitzschutzanlage beschädigt worden sein und es wäre daher eine Überprüfung derselben notwendig.

Bekannte Geräte zur Anzeige eines stattgefundenen Stromdurchganges in Leitungen von Blitzschutzanlagen funktionieren nach Art von Schmelzsicherungen und sind nicht besonders funktionssicher.

Die Erfindung hat es sich daher zum Ziel gesetzt, ein Gerät zu schaffen, das bei einfachem Aufbau eine sichere Anzeige gewährleistet. Erreicht wird dies dadurch, daß an oder nahe der Leitung ein bei Stromdurchgang ansprechender Magnet oder Magnetschalter angeordnet, sowie eine Einrichtung zur Sichtbarmachung des Ansprechens des Magneten bzw. Magnetschalters vorgesehen ist. Im Gegensatz zu den bekannten Geräten wird daher nicht die bei Stromdurchgang erzeugte Wärme sondern der induzierte Magnetismus ausgenützt, um eine Anzeige zu erreichen.

Zur Anzeige von Kurzschlüssen in elektrischen Leitern ist es schon bekannt, Magnetschalter, insbesondere Reedkontakte zu verwenden. Derartige Anzeigegeräte sind jedoch mit erfindungsgemäßen Geräten nicht zu vergleichen, insbesondere wegen völlig verschiedener Zeitspannen eines Stromdurchganges. Bei einer besonders einfachen mechanischen Ausführungsform der Erfindung ist zur Anlage des Magneten ein, einen Teil der Leitung bildender Metallstab, sowie eine vorzugsweise mit einem Schaubereich versehene Tasche od.dgl. für den vom Metallstab abgefallenen Magnet angeordnet. In einem solchen Gerät fällt bei Stromdurchgang der Magnet von dem Metallstab ab und fällt in die Tasche od.dgl. Das Innere der Tasche ist sichtbar und der darin liegende Magnet kann daher leicht wahrgenommen werden.

Eine besonders sichere Wirkung des mechanischen Gerätes wird erreicht, wenn der Metallstab aus nichtrostendem Stahl besteht.

Bei einer weiteren Ausführungsform eines erfindungsgemäßen Gerätes ist der Magnetschalter als Reed-Kontakt ausgebildet, der im Stromkreis einer elektrischen Anzeigevorrichtung liegt. Bei einem solchen Gerät schaltet daher bei Stromdurchgang der Reed-Kontakt die elektrische Anzeigevorrichtung ein.

Diese Anzeigevorrichtung kann auf verschiedene Art ausgebildet sein. Bei einer in Versuchen erprobten Ausführungsform umfaßt der Stromkreis eine Blink LED sowie einen LED Flasher Linear IC.

Sind bei einem solchen Gerät zur Stromversorgung des Stromkreises NC Akkus und Solarzellen angeordnet, ist das Gerät völlig wartungsfrei.

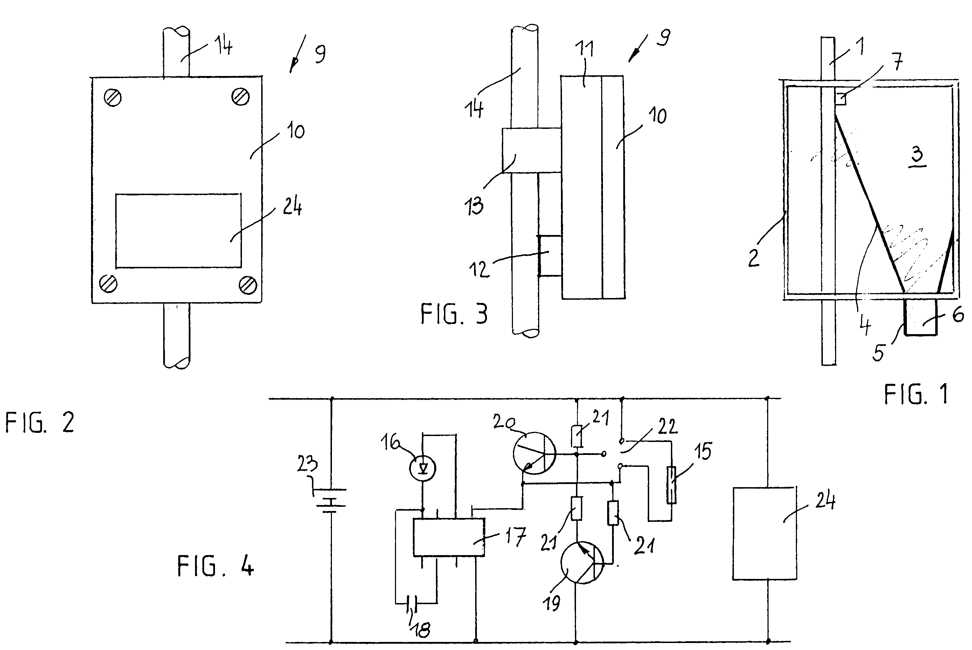

Nachstehend ist die Erfindung an Hand von in den Zeichnungen dargestellten Ausführungsbeispielen näher beschrieben. Dabei zeigen: Fig.1 in Ansicht ein mechanisches Gerät nach der Erfindung; Fig.2 die Vorderansicht eines elektrischen Gerätes; Fig.3 die Seitenansicht dieses elektrischen Gerätes und Fig.4 das Schaltbild des Gerätes nach den Fig.2 und 3.

Gemäß Fig.1 ist ein Metallstab 1 aus nichtrostendem Stahl durch ein Gehäuse 2 hindurchgeführt. Dieses Gehäuse 2 besteht aus nichtmagnetisierbarem Material, insbesondere aus einem Kunststoff. Die Vorderseite des Gehäuses 2 ist mit einer durchsichtigen Scheibe 3 abgedeckt.

Eine schräge Führung 4 erstreckt sich vom oberen Teil des Gehäuses 2 bis zu einer Tasche 5, die ebenfalls mit einer durchsichtigen Scheibe 6 abgedeckt ist. Oberhalb des oberen Endes der Führung 4 haftet am Metallstab 1 ein Magnet 7.

Der Metallstab 1 ist derart mit einer Blitzschutzanlage verbunden, daß bei einem Blitzeinschlag durch ihn Strom fließt. Durch diesen Strom wird ein Magnetfeld induziert, das den Magneten 7 zum Abfallen bringt. Der Magnet 7 fällt daher, geleitet von der Führung 4, in die Tasche 5 und es kann so leicht festgestellt werden, ob ein Stromdurchgang stattgefunden hat.

Beim Ausführungsbeispiel nach den Fig.2 bis 4 sind in einem Gehäuse 9 die Bauteile gemäß Fig.4 untergebracht. Das Gehäuse 9 weist einen durch einen Deckel 10 verschlossenen Unterteil 11 auf, von dem ein Ansatz 12 ausragt. Über einen Halter 13 kann das Gehäuse 9 an einer Leitung 14 der Blitzschutzanlage derart befestigt werden, daß der Ansatz 12 an dieser Leitung 14 anliegt.

Im Ansatz 12 ist ein Reed-Kontakt 15 angeordnet, vorzugsweise eingegossen, der einen Teil des Stromkreises nach Fig.4 bildet. Dieser Stromkreis umfaßt eine Blink LED 16, einen LED Flasher Linear IC 17, einen Kondensator 18, Transistoren 19 und 20, Widerstände 21 sowie einen Schalter 22. Zur Stromversorgung sind zwei NC Akkus 23 sowie Solarzellen 24 vorgesehen.

Bei einem Stromdurchgang durch die Leitung 14 wird zufolge des induzierten Magnetfeldes der Reed-Kontakt 15 geschlossen, ein Halterelais betätigt und die Blink LED 16 beginnt zu blinken. Zufolge der Anordnung der Solarzellen 24 und der aufladbaren NC Akkus 23 sowie des äußerst geringen Stromverbrauches der Blink LED 16 blinkt diese wochenlang. Es wird daher auf eine sehr auffällige Art ein stattgefundener Stromdurchgang angezeigt. Durch eine Betätigung des Schalters 22 (1 + 3 = Set, 1 + 2 = Reset) kann nach einer Überprüfung der Blitzschutzanlage die Anzeigebereitschaft wieder hergestellt werden.

Im Rahmen der Erfindung sind zahlreiche Abänderungen möglich. So könnte bei einer mechanischen Ausführung ähnlich Fig.1 der Metallstab 1 waagrecht oberhalb einer unter dem anliegenden Magneten 7 vorgesehenen Tasche angeordnet werden. Die Tasche od.dgl. müßte auch nicht mit einem Schaubereich versehen werden, weil auch das Abfallen des Magneten 7 schon sichtbar ist.

Die Anzeigevorrichtung bei der elektrischen Ausführung könnte z.B. auch eine akustische Anzeigevorrichtung sein bzw. wäre eine Koppelung einer visuellen mit einer akustischen Anzeigevorrichtung möglich.

## Patentansprüche

1. Gerät zur Anzeige eines stattgefundenen Stromdurchganges in Leitungen von Blitzschutzanlagen, **dadurch gekennzeichnet,** daß in an sich bekannter Weise an oder nahe der Leitung (1,14) ein bei Stromdurchgang ansprechender Magnet (7) oder Magnetschalter (15) angeordnet sowie eine Einrichtung (5,16) zur Sichtbarmachung des Ansprechens des Magneten oder Magnetschalters vorgesehen ist.

2. Gerät nach Anspruch 1, **dadurch gekennzeichnet,** daß zur Anlage des Magneten (7) ein einen Teil der Leitung bildender Metallstab (1) sowie eine vorzugsweise mit einem Schaubereich versehene Tasche (5) od. dgl. für den vom Metallstab (1) abgefallenen Magnet (7) angeordnet ist.

3. Gerät nach Anspruch 2, **dadurch gekennzeichnet,** daß der Metallstab (7) aus nichtrostendem Stahl besteht.

4. Gerät nach Anspruch 1, **dadurch gekennzeichnet,** daß der Magnetschalter in an sich bekannter weise als Reed-Kontakt (15) ausgebildet ist, der im Stromkreis einer elektrischen Anzeigevorrichtung (16) liegt.

5. Gerät nach Anspruch 4, **dadurch gekennzeichnet,** daß der Stromkreis eine Blink LED (16) sowie einen LED Flasher Linear IC (17) umfaßt.

6. Gerät nach Anspruch 1, **dadurch gekennzeichnet,** daß zur Stromversorgung des Stromkreises NC Akkus (23) und Solarzellen (24) angeordnet sind.
